# EUROPEAN PATENT SPECIFICATION

(11) **EP 2 294 626 B1**
(45) Date of publication and mention of the grant of the patent: **22.05.2013**
(21) Application number: 08790052.8
(22) Date of filing: 10.07.2008
(51) Int. Cl.: H01L 31/048

(54) **Flexible photovoltaic panel and process for manufacturing such panel**
Flexible Photovoltaiktafel und Prozess zur Herstellung einer solchen Tafel
Panneau photovoltaïque flexible et procédé de fabrication d'un tel panneau

(43) Date of publication of application: 16.03.2011
(73) Proprietor: Enecom Italia S.r.l., 10099 San Mauro Torinese (TO) (IT)
(72) Inventor: AVESANI, Diego, I-37059 Zevio (VR) (IT)
(74) Representative: Notaro, Giancarlo
(86) International application number: PCT/IT2008/000463
(87) International publication number: WO 2010/004599

(56) References cited:
- EP-A- 1 302 988
- WO-A-97/50130
- US-A- 4 860 509

## Description

The present invention refers to a flexible photovoltaic panel and to a process for manufacturing such panel. The photovoltaic panel deriving from such process has high efficiency characteristics, and is bendable and capable to be treaded onto without difficulty.

Photovoltaic panels of the rigid type are already known in the art. Some rare solutions, instead, provide for a kind of photovoltaic panels of the flexible type, which panels however have the inconvenience of having low efficiency, being made of amorphous silica. Since current highly-efficient panels have photovoltaic cells made of monocrystal and polycrystal silica that are extremely brittle and undeformable under normal conditions, it is in practice impossible to couple these cells with a flexible panel that can be adapted to several types of applications that require it.

**A photovoltaic panel according to the preamble of claim 1 is known from any of documents** US 4 860 509 A **and** IT TO 2005 0467**. A panel manufacturing process according to the preambles of claims 7 and 8 is known from any of documents** WO 97/50130 **and** EP 1 302 988 A2**.**

Object of the present invention is solving the above prior art problems, by providing a photovoltaic panel that is able to be flexible, namely capable of being adapted to a high number of end applications, to be bendable and lightweight, namely adapted to be easily transported and applied where necessary, and to be treaded onto, namely adapted to be used in all those context in which the surface is used (such as, for example, in campers or ships) . This panel further has a high efficiency characteristic, being composed of photovoltaic cells made of monocrystal and polycrystal silica, that before were unusable for making this type of panel.

Moreover, an object of the present invention is providing for a process for making a flexible photovoltaic panel as described above.

With the above-described panel, it is therefore possible to extend the applicability of photovoltaic generators in sectors in which it is necessary to have high efficiency on small surfaces with reduced weights, such as for example in the automotive, aeronautical, ship and camper sectors.

The above and other objects and advantages of the invention, as will appear from the following description, are obtained with a flexible photovoltaic panel and with a process for manufacturing such panel, as claimed in the respective independent claims.

Preferred embodiments and non-trivial variations of the present invention are the subject matter of the dependent claims.

It will be immediately obvious that many variations and modifications (for example related to shape, sizes, arrangements and parts with equivalent functionality) can be made to what is described, without departing from the scope of the invention as appears from the enclosed claims.

The present invention will be better described by some preferred embodiments thereof, provided as a nonlimiting example, with reference to the enclosed drawings, in which:

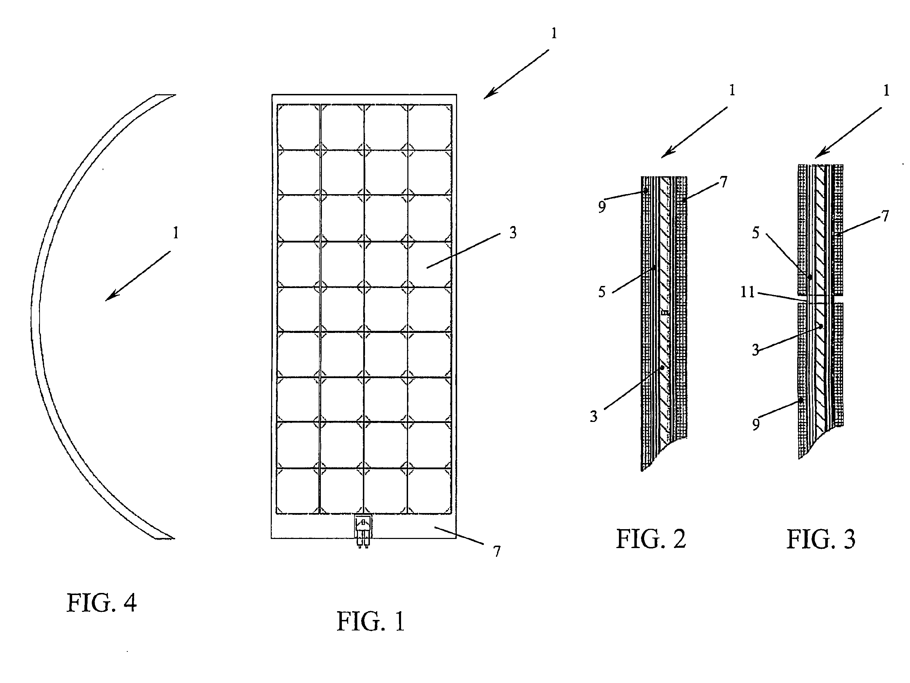

- FIG. 1 shows a top view of an embodiment of the photovoltaic panel of the present invention;
- FIG. 2 shows a side sectional view of an example of a panel;
- FIG. 3 shows a side sectional view of a detail of the panel of FIG. 1; and
- FIG. 4 shows a side view of the panel of Fig. 1 in its bent position.

With reference to the Figures, a preferred, but not limiting, embodiment of the photovoltaic panel 1 of the present invention, will be described.

Such flexible panel 1 is substantially composed of:
- a plurality of photovoltaic cells 3, that are preferably cells made of high-efficiency monocrystal and polycrystal silica, in order to widen the field of application of the panel 1;
- at least one encapsulating layer 5 made of thermoplastic material adapted to contain therein the photovoltaic cells 3; and
- at least one layer 7 made of flexible plastic material resistant to ultraviolet rays, joined and overlapped to the encapsulating layer 5 on a first surface thereof: such layer 7 is the one that will then be exposed to sunlight during use.

The above described panel is also preferably equipped with at least one reinforcing layer 9 made of flexible plastic material, joined and overlapped to the encapsulating layer 5 on a second surface thereof, that is opposite to the first surface of the encapsulating layer 5.

The layer 7 made of flexible plastic material, in order to be made resistant to ultraviolet sun rays, could for example be subjected to an adequate treatment for such purpose, or could be equipped with a film (not shown) for protecting it from ultraviolet rays.

According to the currently preferred embodiment of the invention, then, the encapsulating layer 5 is made of polyurethane thermoplastic resin, while the layer 7 made of flexible plastic material is a layer of polycarbonate, as well as the reinforcing layer 9 made of flexible plastic material that is also a layer of polycarbonate.

In order to make its bending easier, the photovoltaic panel 1 is adapted to be bent in many points next to hinges 11 present in the encapsulating layer 5 between a photovoltaic cell 3 and another adjacent cell 3. The bending hinge 11 can be made in various thicknesses, through suitable thermo-deformation of the layer 5.

The above-described photovoltaic panel 1 thereby obtains all its foreseen characteristics, namely it is flexible, bendable, lightweight, capable of being treaded thereon and with high efficiency.

In order to manufacture it, it is foreseen to use a first process that comprises the steps of:
- providing the reinforcing layer 9;
- placing a first encapsulating layer 5 over the reinforcing layer 9;
- placing a plurality of photovoltaic cells 3 in a layer over the encapsulating layer 5;
- placing a second encapsulating layer 5 over the plurality of photovoltaic cells 3;
- placing a layer made of flexible plastic material 7 resistant to ultraviolet rays over the second encapsulating layer 5;
- heating the layers 7, 5, 3, 5, 9 at such a temperature as to generate the melting of the first and the second encapsulating layers 5 around the photovoltaic cells 3;
- subjecting to vacuum the heated layers 7, 5, 3, 5, 9 in order to remove possible air bubbles being present; and
- subjecting to pressure the layers 7, 5, 3, 5, 9 in order to join them to form the final photovoltaic panel 1.

In an alternative embodiment using known calendering means (not shown), the process for manufacturing a flexible photovoltaic panel 1 as described above comprises the steps of:
- providing the reinforcing layer 9;
- placing a first encapsulating layer 5 over the reinforcing layer 9;
- placing a plurality of photovoltaic cells 3 in a layer over the encapsulating layer 5;
- placing a second encapsulating layer 5 over the plurality of photovoltaic cells 3;
- placing a layer made of flexible plastic material 7 resistant to ultraviolet rays over the second encapsulating layer 5;
- pre-heating the layers 7, 5, 3, 5, 9 at such a temperature as to generate the melting of the first and the second encapsulating layer 5 around the photovoltaic cells 3;
- calendering the pre-heated layers 7, 5, 3, 5, 9 through calendering means in turn heated at a temperature greater than the pre-heating temperature: such calendering step also removes possible air bubbles being present; and
- cooling the calendered layers 7, 5, 3, 5, 9 in order to form the final photovoltaic panel 1.

Both above-mentioned processes can be integrated, still in an innovative way, by a further final step of thermoforming the photovoltaic panel 1 at a lower temperature than the temperature of the previous steps, in order to build a photovoltaic panel 1 shaped according to a bi-axial shape, that can then be immediately used in end applications, for example of the automotive type.

## Claims

1. Flexible photovoltaic panel (1), comprising:
- a plurality of photovoltaic cells (3);
- at least one encapsulating layer made of thermoplastic material adapted to contain therein said photovoltaic cells (3), said encapsulating layer being formed by first and second layers (5) of polyurethane thermoplastic resin located on opposite sides of said plurality of photovoltaic cells (3) and melted around the photovoltaic cells (3); and
- at least one front layer (7) joined and overlapped to said encapsulating layer on a first surface thereof, said front layer (7) being exposed to sunlight during use,
**wherein:**
- said at least one front layer (7) is made of flexible plastic material, said material being resistant to ultraviolet rays,
- said flexible panel further compris**es** at least one reinforcing layer (9) made of flexible plastic material, joined and overlapped to said encapsulating layer on a second surface thereof, opposite to said first surface,
**and wherein said photovoltaic panel (1) is adapted to be bent in many points next to hinges (11) present in the encapsulating layer (5) between a photovoltaic cell (3) and another adjacent cell (3),**
**characterized in that each of said bending hinges (11) is constituted by said encapsulating layer (5), said front and reinforcing layers (7,9) being not present at said hinge points.**

2. Flexible photovoltaic panel (1) according to claim 1, **characterised in that** said photovoltaic cells (3) are cells made of high-efficiency monocrystal and polycrystal silica.

3. Flexible photovoltaic panel (1) according to claim 1, **characterised in that** said at least one front layer (7) made of flexible plastic material is adapted to be resistant to ultraviolet rays or to be subjected to such a treatment as to make it resistant to ultraviolet rays.

4. Flexible photovoltaic panel (1) according to claim 1, **characterised in that** said at least one front layer (7) made of flexible plastic material is equipped with a film for protecting it from ultraviolet rays.

5. Flexible photovoltaic panel (1) according to claim 1, **characterised in that** said front layer (7) made of flexible plastic material is a layer of polycarbonate.

6. Flexible photovoltaic panel (1) according to claim 1, **characterized in that** said reinforcing layer (9) made of flexible plastic material is a layer of polycarbonate.

7. Process for manufacturing the flexible photovoltaic panel (1) of claim 1, said process comprising the steps of:
- providing a first encapsulating layer (5);
- placing a plurality of photovoltaic cells (3) in a layer over said first encapsulating layer (5) ;
- placing a second encapsulating layer (5) over the plurality of photovoltaic cells (3) ;
- placing a front layer (7), which is to be exposed to sunlight during use, over said second encapsulating layer (5) ;
- heating said layers (7, 5, 3, 5, 9) at such a temperature as to generate a melting of the first and the second encapsulating layers (5) around the photovoltaic cells (3);
- subjecting to vacuum said heated layers (7, 5, 3, 5, 9) in order to remove possible air bubbles being present; and
- subjecting to pressure said layers (7, 5, 3, 5, 9) in order to mutually join them to form the final photovoltaic panel (1),
**characterized in that**:
- said process starts by providing a reinforcing layer (9) made of flexible plastic material and placing said first encapsulating layer (5) over the reinforcing layer (9); and
- said front layer (7) is made of flexible plastic material resistant to ultraviolet rays, **and**
**in that said panel is formed with hinges (11) present in the encapsulating layer (5) between adjacent photovoltaic cells (3) by a thermo-deformation of said encapsulating layer (5), said front and reinforcing layers (7,9) being not present at the hinge points.**

8. Process for manufacturing **the** flexible photovoltaic panel (1) **of claim 1,** said process comprising the steps of:
- providing a first encapsulating layer (5);
- placing a plurality of photovoltaic cells (3) in a layer over said first encapsulating layer (5) ;
- placing a second encapsulating layer (5) over the plurality of photovoltaic cells (3);
- placing a front layer (7), which is to be exposed to sunlight during use, over the second encapsulating layer (5) ;
- pre-heating said layers (7, 5, 3, 5, 9) at such a temperature as to generate a melting of the first and the second encapsulating layer (5) around the photovoltaic cells (3);
- calendering said pre-heated layers (7, 5, 3, 5, 9) through calendering means in turn heated at a higher temperature than the pre-heating temperature, said calendering step also removing possible air bubbles being present; and
- cooling said calendered layers (7, 5, 3, 5, 9) in order to form said final photovoltaic panel (1), **characterized in that**:
- said process starts by providing a reinforcing layer (9) made of flexible plastic material and placing said first encapsulating layer (5) over the reinforcing layer (9); and
- said front layer (7) is made of flexible plastic material resistant to ultraviolet rays, **and**
**in that said panel is formed with hinges (11) present in the encapsulating layer (5) between adjacent photovoltaic cells (3) by a thermo-deformation of said encapsulating layer (5), said front and reinforcing layers (7,9) being not present at the hinge points.**

9. Process according to claim **7** or **8**, further comprising the step of thermoforming the photovoltaic panel (1) at a lower temperature than the temperature of the previous steps, in order to build a bi-axially shaped photovoltaic panel (1).

## Patentansprüche

1. Flexibles photovoltaisches Paneel (1), das umfasst:
eine Vielzahl von photovoltaischen Zellen (3),
wenigstens eine einkapselnde Schicht aus einem thermoplastischen Material zum Aufnehmen der photovoltaischen Zellen (3), wobei die einkapselnde Schicht durch erste und zweite Schichten (5) aus einem thermoplastischen Polyurethan-Kunstharz gebildet wird, die auf gegenüberliegenden Seiten der Vielzahl von photovoltaischen Zellen (3) angeordnet und um die photovoltaischen Zellen (3) herum geschmolzen werden, und
wenigstens eine vordere Schicht (7), die mit der einkapselnden Schicht an einer ersten Fläche derselben verbunden ist und diese überlappt, wobei die vordere Schicht (7) während der Nutzung dem Sonnenlicht ausgesetzt wird,
wobei die wenigstens eine vordere Schicht (7) aus einem flexiblen Kunststoffmaterial ausgebildet ist, wobei das Material gegenüber ultravioletten Strahlen beständig ist,
wobei das flexible Paneel weiterhin wenigstens eine Verstärkungsschicht (9) aus einem flexiblen Kunststoffmaterial umfasst, die mit der einkapselnden Schicht auf einer zweiten Fläche derselben gegenüber der ersten Fläche verbunden ist und diese überlappt, und
wobei das photovoltaische Paneel (1) ausgebildet ist, um an vielen Punkten in Nachbarschaft zu Scharnieren (11) in der einkapselnden Schicht (5) zwischen einer photovoltaischen Zelle (3) und einer anderen benachbarten Zelle (3) gebogen zu werden,
**dadurch gekennzeichnet, dass** jedes der Biegungsscharniere (11) durch die einkapselnde Schicht (5) gebildet wird, wobei die vordere Schicht (7) und die verstärkende Schicht (9) nicht an den Scharnierpunkten vorhanden sind.

2. Flexibles photovoltaisches Paneel (1) nach Anspruch 1, **dadurch gekennzeichnet, dass** die photovoltaischen Zellen (3) Zellen aus einem hocheffizienten monokristallinen und polykristallinen Siliciumdioxid sind.

3. Flexibles photovoltaisches Paneel (1) nach Anspruch 1, **dadurch gekennzeichnet, dass** die wenigstens eine vordere Schicht (7) aus einem flexiblen Kunststoffmaterial derart ausgebildet ist, dass sie beständig gegenüber ultravioletten Strahlen ist oder einer Behandlung unterworfen werden kann, um sie beständig gegenüber ultravioletten Strahlen zu machen.

4. Flexibles photovoltaisches Paneel (1) nach Anspruch 1, **dadurch gekennzeichnet, dass** die wenigstens eine vordere Schicht (7) aus einem flexiblen Kunststoffmaterial mit einem Film für einen Schutz gegenüber ultravioletten Strahlen ausgestattet ist.

5. Flexibles photovoltaisches Paneel (1) nach Anspruch 1, **dadurch gekennzeichnet, dass** die vordere Schicht (7) aus einem flexiblen Kunststoffmaterial eine Schicht aus Polycarbonat ist.

6. Flexibles photovoltaisches Paneel (1) nach Anspruch 1, **dadurch gekennzeichnet, dass** die Verstärkungsschicht (9) aus einem flexiblen Kunststoffmaterial eine Schicht aus Polycarbonat ist.

7. Verfahren zum Herstellen des flexiblen photovoltaischen Paneels (1) von Anspruch 1, wobei das Verfahren folgende Schritte umfasst:
Vorsehen einer ersten einkapselnden Schicht (5),
Platzieren einer Vielzahl von photovoltaischen Zellen (3) in einer Schicht über der ersten einkapselnden Schicht (5),
Platzieren einer zweiten einkapselnden Schicht (5) über der Vielzahl von photovoltaischen Zellen (3),
Platzieren einer vorderen Schicht (7), die während der Nutzung dem Sonnenlicht ausgesetzt wird, über der zweiten einkapselnden Schicht (5),
Erhitzen der Schichten (7, 5, 3, 5, 9) auf eine derartige Temperatur, dass ein Schmelzen der ersten und zweiten einkapselnden Schichten (5) um die photovoltaischen Zellen (3) herum veranlasst wird,
Anwenden eines Vakuums auf die erhitzten Schichten (7, 5, 3, 5, 9), um möglicherweise vorhandene Luftblasen zu entfernen, und
Ausüben eines Drucks auf die Schichten (7, 5, 3, 5, 9), um diese miteinander zu verbinden und das endgültige photovoltaische Paneel (1) zu bilden,
**dadurch gekennzeichnet, dass**:
das Verfahren damit beginnt, eine Verstärkungsschicht (9) aus einem flexiblen Kunststoffmaterial vorzusehen und die erste einkapselnde Schicht (5) über der Verstärkungsschicht (9) zu platzieren,
die vordere Schicht (7) aus einem flexiblen Kunststoffmaterial ausgebildet ist, das gegenüber ultravioletten Strahlen beständig ist, und
das Paneel mit Scharnieren (11) in der einkapselnden Schicht (5) zwischen benachbarten photovoltaischen Zellen (3) durch eine Wärmeverformung der einkapselnden Schicht (5) versehen wird, wobei die vordere Schicht (7) und die Verstärkungsschicht (9) nicht an den Scharnierpunkten vorhanden sind.

8. Verfahren zum Herstellen des flexiblen photovoltaischen Paneels (1) von Anspruch (1), wobei das Verfahren folgende Schritte aufweist:
Vorsehen einer ersten einkapselnden Schicht (5),
Platzieren einer Vielzahl von photovoltaischen Zellen (3) in einer Schicht über der ersten einkapselnden Schicht (5),
Platzieren einer zweiten einkapselnden Schicht (5) über der Vielzahl von photovoltaischen Zellen (3)
Platzieren einer vorderen Schicht (7), die während der Nutzung dem Sonnenlicht ausgesetzt wird, über der zweiten einkapselnden Schicht (5),
Vorheizen der Schichten (7, 5, 3, 5, 9) auf eine derartige Temperatur, dass ein Schmelzen der ersten und zweiten einkapselnden Schichten (5) um die photovoltaischen Zellen (3) herum veranlasst wird,
Kalandern der vorgeheizten Schichten (7, 5, 3, 5, 9) unter Verwendung einer Kalandereinrichtung, die wiederum auf eine höhere Temperatur als die Vorheiztemperatur erhitzt ist, wobei der Kalanderschritt auch möglicherweise vorhandene Luftblasen entfernt,
und
Kühlen der kalandrierten Schichten (7, 5, 3, 5, 9), um das endgültige photovoltaische Paneel (1) zu bilden,
**dadurch gekennzeichnet, dass**:
das Verfahren damit beginnt, eine Verstärkungsschicht (9) aus einem flexiblen Kunststoffmaterial vorzusehen und die erste einkapselnde Schicht (5) über der Verstärkungsschicht (9) zu platzieren,
die vordere Schicht (7) aus einem flexiblen Kunststoffmaterial ausgebildet ist, das gegenüber ultravioletten Strahlen beständig ist, und
das Paneel mit Scharnieren (11) in der einkapselnden Schicht (5) zwischen benachbarten photovoltaischen Zellen (3) durch eine Wärmeverformung der einkapselnden Schicht (5) versehen wird, wobei die vordere Schicht (7) und die Verstärkungsschicht (9) nicht an den Scharnierpunkten vorhanden sind.

9. Verfahren nach Anspruch 7 oder 8, weiterhin **gekennzeichnet durch** einen Schritt zum Wärmeformen des photovoltaischen Paneels (1) mit einer Temperatur, die niedriger ist als die Temperatur der vorausgehenden Schritte, um ein biaxial geformtes photovoltaisches Paneel (1) auszubilden.

## Revendications

1. Panneau photovoltaïque flexible (1), comprenant :
- une pluralité de cellules photovoltaïques (3) ;
- au moins une couche d'encapsulation composée d'un matériau thermoplastique adapté pour contenir lesdites cellules photovoltaïques (3), ladite couche d'encapsulation étant formée par une première et une seconde couches (5) de résine thermoplastique en polyuréthane située sur les côtés opposés de ladite pluralité de cellules photovoltaïques (3) et fondues autour desdites cellules photovoltaïques (3) ; et
- au moins une couche avant (7) jointe à et chevauchant ladite couche d'encapsulation sur une première surface de celle-ci, ladite couche avant (7) étant exposée aux rayons du soleil pendant l'utilisation, dans lequel
- ladite au moins une couche avant (7) est composée d'un matériau plastique flexible, ledit matériau étant résistant aux rayons ultraviolets,
- ledit paneau flexible comprend en outre au moins une couche de renfort (9) composée d'un matériau plastique flexible, jointe à et chevauchant ladite couche d'encapsulation sur une seconde surface de celle-ci, opposée à ladite première surface,
ledit panneau photovoltaïque (1) étant adapté pour être cintré en de nombreux points près de charnières (11) présentes dans ladite couche d'encapsulation (5) entre une cellule photovoltaïque (3) et une autre cellule adjacente (3),
**caractérisé en ce que** chacune desdites charnières cintrées (11) est constituée de ladite couche d'encapsulation (5), ladite couche avant et ladite couche de renfort (7, 9) n'étant pas présentes au niveau desdits points de charnières.

2. Panneau photovoltaïque flexible (1) selon la revendication 1, **caractérisé en ce que** lesdites cellules photovoltaïques (3) sont des cellules composées de silice monocristalline et polycristalline à haute efficacité.

3. Panneau photovoltaïque flexible (1) selon la revendication 1, **caractérisé en ce que** ladite au moins une couche avant (7) composée d'un matériau plastique flexible est adaptée pour être résistante aux rayons ultraviolets ou pour être soumise à un traitement destiné à la rendre résistante aux rayons ultraviolets.

4. Panneau photovoltaïque flexible (1) selon la revendication 1, **caractérisé en ce que** ladite au moins une couche avant (7) composée d'un matériau plastique flexible est équipée d'un film destiné à la protéger contre les rayons ultraviolets.

5. Panneau photovoltaïque flexible (1) selon la revendication 1, **caractérisé en ce que** ladite couche avant (7) composée d'un matériau plastique flexible est une couche de polycarbonate.

6. Panneau photovoltaïque flexible (1) selon la revendication 1, **caractérisé en ce que** ladite couche de renfort (9) composée d'un matériau plastique flexible est une couche de polycarbonate.

7. Procédé de fabrication du panneau photovoltaïque flexible (1) selon la revendication 1, qui comprend les étapes consistant à :
- prévoir une première couche d'encapsulation (5) ;
- placer une pluralité de cellules photovoltaïques (3) au sein d'une couche par-dessus ladite première couche d'encapsulation (5) ;
- placer une seconde couche d'encapsulation (5) par-dessus ladite pluralité de cellules photovoltaïques (3) ;
- placer une couche avant (7), qui doit être exposée aux rayons du soleil pendant l'utilisation, par-dessus ladite seconde couche d'encapsulation (5) ;
- chauffer lesdites couches (7, 5, 3, 5, 9) à une température qui permet de faire fondre lesdites première et seconde couches d'encapsulation (5) autour desdites cellules photovoltaïques (3) ;
- soumettre à un vide lesdites couches chauffées (7, 5, 3, 5, 9) afin de supprimer les bulles d'air éventuellement présentes ; et
- soumettre à une pression lesdites couches (7, 5, 3, 5, 9) afin de les joindre mutuellement de façon à former le panneau photovoltaïque final (1),
**caractérisé en ce que** :
- ledit procédé commence par le fait de prévoir une couche de renfort (9) composée d'un matériau plastique flexible et de placer ladite première couche d'encapsulation (5) par-dessus ladite couche de renfort (9) ; et
- ladite couche avant (7) est composée d'un matériau plastique flexible résistant aux rayons ultraviolets, et
**en ce que** ledit panneau est formé avec des charnières (11) présentes dans ladite couche d'encapsulation (5) entre des cellules photovoltaïques adjacentes (3), à l'aide d'une déformation thermique de ladite couche d'encapsulation (5), ladite couche avant et ladite couche de renfort (7, 9) n'étant pas présentes au niveau desdits points de charnières.

8. Procédé de fabrication du panneau photovoltaïque flexible (1) selon la revendication 1, qui comprend les étapes consistant à :
- prévoir une première couche d'encapsulation (5) ;
- placer une pluralité de cellules photovoltaïques (3) au sein d'une couche par-dessus ladite première couche d'encapsulation (5) ;
- placer une seconde couche d'encapsulation (5) par-dessus ladite pluralité de cellules photovoltaïques (3) ;
- placer une couche avant (7), qui doit être exposée aux rayons du soleil pendant l'utilisation, par-dessus ladite seconde couche d'encapsulation (5) ;
- préchauffer lesdites couches (7, 5, 3, 5, 9) à une température qui permet de faire fondre lesdites première et seconde couches d'encapsulation (5) autour desdites cellules photovoltaïques (3) ;
- calandrer lesdites couches préchauffées (7, 5, 3, 5, 9) à l'aide d'un moyen de calandrage à son tour chauffé à une température supérieure à la température de préchauffage, ladite étape de calandrage supprimant également les bulles d'air éventuellement présentes ; et
- refroidir lesdites couches calandrées (7, 5, 3, 5, 9) afin de former ledit panneau photovoltaïque final (1),
**caractérisé en ce que** :
- ledit procédé commence par le fait de prévoir une couche de renfort (9) composée d'un matériau plastique flexible et de placer ladite première couche d'encapsulation (5) par-dessus ladite couche de renfort (9) ; et
- ladite couche avant (7) est composée d'un matériau plastique flexible résistant aux rayons ultraviolets, et
**en ce que** ledit panneau est formé avec des charnières (11) présentes dans ladite couche d'encapsulation (5) entre des cellules photovoltaïques adjacentes (3), à l'aide d'une déformation thermique de ladite couche d'encapsulation (5), ladite couche avant et ladite couche de renfort (7, 9) n'étant pas présentes au niveau desdits points de charnières.

9. Procédé selon la revendication 7 ou 8, qui comprend en outre l'étape de thermoformage dudit panneau photovoltaïque (1) à une température inférieure à celle des étapes précédentes, afin de créer un panneau photovoltaïque à forme bi-axiale (1).
